Europäisches Patentamt

European Patent Office

Office européen des brevets

(11) Veröffentlichungsnummer: **0 301 471 B1**

# EUROPÄISCHE PATENTSCHRIFT

(45) Veröffentlichungstag der Patentschrift: **27.05.92**

(51) Int. Cl.⁵: **H01L 31/06,** H01L 31/18

(21) Anmeldenummer: **88112008.3**

(22) Anmeldetag: **26.07.88**

(54) **Verfahren zur Wiederverwendung von Silizium-Basismaterial einer Metall-Isolator-Halbleiter-(MIS)-Inversionsschicht-Solarzelle.**

(30) Priorität: **30.07.87 DE 3725346**

(43) Veröffentlichungstag der Anmeldung:
**01.02.89 Patentblatt 89/05**

(45) Bekanntmachung des Hinweises auf die
Patenterteilung:
**27.05.92 Patentblatt 92/22**

(84) Benannte Vertragsstaaten:
**DE ES FR IT SE**

(56) Entgegenhaltungen:
**EP-A- 0 219 763**
**US-A- 4 255 208**
**US-A- 4 322 571**

**EIGHTEENTH IEEE PHOTOVOLTAIC SPECIA-LISTS CONFERENCE-1985, Las Vegas, Nevada, 21.-25. Oktober 1985, Seiten 1008-1013, IEEE, New York, US; S.R. WENHAM et al.: "Efficiency improvement in screen printed polycrystalline silicon solar cells by plasma treatments"**

(73) Patentinhaber: **Nukem GmbH**
**Industriestrasse 13**
**W-8755 Alzenau(DE)**

(72) Erfinder: **Hezel, Rudolf, Prof. Dr.**
**Ringstrasse 23**
**W-8521 Spardorf(DE)**
Erfinder: **Hoffman, Winfried, Dr. Dipl.-Phys**
**Bergstrasse 48**
**W-6450 Hanau 7(DE)**
Erfinder: **Schum, Berthold, Ing.(FH)**
**Bornweg 44**
**W-6465 Biebergemünd 1(DE)**

(74) Vertreter: **Stoffregen, Hans-Herbert, Dr. Dipl.-Phys.**
**Patentanwalt, Salzstrasse 11 a, Postfach 21 44**
**W-6450 Hanau (Main) 1(DE)**

## Beschreibung

Die Erfindung bezieht sich auf ein Verfahren zur Herstellung von solarzellen durch Wiederverwendung dung von Silizium-Basismaterial (S) einer Metall-Isolator-Halbleiter-(MIS)-Inversionsschicht-Solarzelle, bei der auf einer Seite des Basismaterials ein erster elektrisch leitender flächig oder partiell ausgebildeter Kontakt und auf der gegenüberliegenden Seite die MIS-solarzellenspezifischen Schichten in Form einer ersten Isolatorschicht (I) wie Siliziumoxidschicht, ein auf dieser vorhandener vorzugsweise in Gitter- oder Fingerform ausgebildeter zweiter elektrisch leitender Kontake (M) sowie eine weitere Isolatorschicht wie Siliziumnitrid- oder -oxinitrid-Schicht angeordnet sind.

Die weltweite Entwicklung der Photovoltaik zur terrestrischen Nutzung ist durch das Bemühen um stetige Kostenreduzierung bei der Herstellung der Solarzellen gekennzeichnet. Insbesondere mit der z.B. aus der DE-PS 28 46 096 bekannten MIS-Inversionsschicht-Solarzelle, bei der billiges polykristallines Solarzellen-Silizium genutzt werden kann, ist ein gewaltiger Fortschritt erzielt worden, da sich bei günstigen Herstellungskosten ein hoher Wirkungsgrad ergibt.

Das Basismaterial einer entsprechenden Zelle besteht aus ein oder polykristallinem p-leitendem Silizium. Rückseitig ist ein erster elektrisch leitender Kontakt -partiell oder flächig aufgetragen. Auf der gegenüberliegenden Seite ist vorzugsweise durch einen kurzen thermischen Oxidationsprozeß bei relativ niedriger Temperatur (ca. 500°C) eine in etwa 1,5 nm dicke Siliziumoxidschicht als Isolator-Schicht aufgebracht. Anschließend wird der als zweiter elektrisch leitender Kontakt zu bezeichnende Frontkontakt aufgebracht, der Finger- oder Gitterstruktur aufweisen sollte. Nach Aufbringen dieses Kontaktes wird in einem anschließenden Tauchprozeß in einer Alkalimetall-haltigen Lösung -vorzugsweise Cäsium- die Oberfläche der Siliziumoxidschicht mit Alkali-Ionen, insbesondere Cäsium-Ionen belegt. Anschließend wird eine zweite Isolatorschicht vorzugsweise in Form von Siliziumnitrid oder -oxinitrid aufgetragen. Dies erfolgt mit einem plasmaunterstützten CVD- (chemical vapour deposition) Verfahren bei niedrigen Temperaturen (ca. 250°C), wobei eine ca. 80 nm dicke Siliziumnitrid- oder -oxinitrid-Schicht abgeschieden wird, welche die Alkali-Ionen wie Cäsium-Ionen in ihrer Lage festhält. Durch Influenz wird im Silizium-Basismaterial die notwendige Inversionsschicht erzeugt. Die Siliziumnitrid- oder -oxinitrid-Schicht wirkt gleichzeitig als Antireflexionsschicht.

Die Wirkungsweise des MIS-Inversions-Schicht-Solarzellen-Typs läßt sich nun wie folgt beschreiben.

Zwischen den den zweiten elektrischen Kontakt bildenden Bereichen einfallendes Licht erzeugt im Silizium-Basismaterial Elektron-Loch-Paare, die in einem elektrischen Feld getrennt werden. Dieses wird durch das Vorhandensein einer ortsfesten, positiven Flächenladung an der Nitrid-Oxid-Grenzschicht erzeugt, die in der dem Oxid zugewandten Silizium-Seite eine vergleichbare Ladung an beweglichen Elektronen und einer Verarmungszone daran anschließend induziert. Die eine Dicke von ca. 10 bis 50 nm aufweisende Schicht mit den beweglichen Elektronen ändert oder invertiert den Leitungstyp des Silizium-Basismatrials. Die separierten Löcher diffundieren zum ersten elektrisch leitenden Kontakt, der Rückseitenelektrode, während die Elektronen innerhalb der gut leitenden Inversionsschicht hin zu dem vorzugweise in Steg- oder Gitterform ausgebildeten zweiten elektrisch leitenden Kontakt wandern, durch die Siliziumoxid-Schicht tunneln und in den äußeren Stromkreis gelangen.

Solarzellen, die nicht spezifikationsgerecht sind -sei es herstellungs- oder alterungsbedingt- werden als Ausschuß behandelt. Wünschenswert wäre es jedoch, entsprechende Solarzellen oder zumindest Bereiche dieser weiterverwenden zu können, wodurch sich die Gesamtkosten bei der Herstellung entsprechender MIS-Inversionsschicht-Solarzellen reduzieren würden.

Es ist daher Aufgabe der vorliegenden Erfindung, ein Verfahren zur Wiederverwendung von Silizium-Basismaterial einer MIS-Inversionsschicht-Solarzelle zur Verfügung zu stellen, das kostengünstig und technisch einfach durchzuführen ist.

Die Aufgabe wird im wesentlichen dadurch gelöst, daß zumindest MIS-solarzellenspezifischen Schichten in Form der zweiten Isolatorschicht und des zweiten elektrisch leitenden Kontakts abgetragen und durch entsprechende neue Schichten ersetzt werden. Hierdurch ergibt sich der Vorteil, daß das Silizium-Basismaterial einer nicht spezifikationsgerechten -defekten oder gealterten- Solarzelle wiederverwendbar ist, das bekanntlich bis zu 30 % die Herstellungskosten einer Solarzelle beeinflußt. Vorzugsweise werden nicht nur die zweite Isolatorschicht und der zweite elektrisch leitende Kontakt, sondern zumindest auch die Alkali-Metall-Ionen in der ersten Isolatorschicht und der erste elektrisch leitende Kontakt abgetragen, um sodann auf die Silizium-Basismaterialscheibe entsprechende Schichten wieder aufzutragen, um eine neue funktionstüchtige MIS-Inversionsschicht-Solarzelle zur Verfügung zu stellen. Zuvor kann die Basismaterialscheibe geätzt werden, um vorhandene Verunreinigungen und/oder Fehlstellen oder ähnliches zu entfernen. Wahlweise können die abzutragenden Schichten selktiv oder als Einheit entfernt werden. Dabei kann ein chemischer oder plasmachemischer Ätzprozeß vorgesehen sein. Um einen zeitsparenden Verfahrensablauf zu ermöglichen, kann vorgesehen sein, daß zunächst die zweite Isolatorschicht und sodann vorzugsweise gleichzeitig der erste und zweite elektrische Kontakt abgetragen werden.

Zum Entfernen des ersten und zweiten elektrisch leitenden Kontakts sowie der zweiten Isolatorschicht kann die MIS-Inversionsschicht-Solarzelle in einer Mineralsäure wie $O-H_3PO_4$ bei einer Temperatur zwischen 50°C und 100°C eingetaucht werden.

Alternativ besteht die Möglichkeit, die zweite Isolatorschicht durch Plasmaätzung z. B. in $C_2F_6/O_2$-Gasphase oder durch plasmachemische Ätzung z.B. in $NF_3$-Gasphase abzutragen. Selbstverständlich besteht auch die Möglichkeit die MIS-solarzellenspezifischen Schichten als Einheit z.B. mechanisch zu entfernen.

Schließlich kann das wiederzuverwendende Silizium-Basismaterial für eine neue MIS-Inversionsschicht-Solarzelle so eingesetzt werden, daß die Rückseite der alten Zelle die Vorderseite der neuen ist und umgekehrt.

Weitere Einzelheiten und Vorteile der Erfindung ergeben sich aus den Ansprüchen und den diesen zu entnehmenden Merkmalen -für sich und/oder in Kombination-.

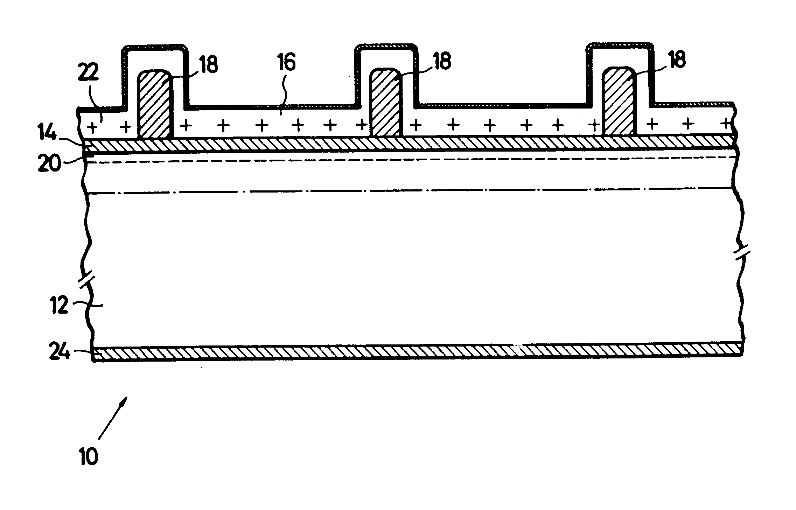

An Hand der nachfolgenden Beschreibung eines der Zeichnung zu entnehmenden Ausführungsbeispiels und von in diesem Zusammenhang beschriebenen Verfahrensabläufen ergeben sich weitere Einzelheiten, Vorteile und Merkmale der Erfindung.

In der einzigen Figur ist rein schematisch eine MIS-Inversionsschicht-Solarzelle (10) dargestellt, die folgenden prinzipiellen Aufbau zeigt. Auf der Vorderseite eines p-dotierten Silizium-Basismaterials (12) ist eine erste Isolatorschicht (14) in Form von Siliziumoxid aufgetragen. Auf dieser befindet sich partiell, vorzugsweise in Form von Fingern oder Gittern ein elektrisch leitender Kontakt (18), über den die in dem Halbleitermaterial durch Lichteinstrahlung entstandenen Minoritätsladungsträger abgeleitet werden. Die Siliziumoxidschicht (14) und der elektrische Kontakt (18) sind sodann von einer zweiten Isolatorschicht (16) in Form von Siliziumnitrid oder Siliziumoxinitrid abgedeckt. Rückseitig ist ein weiterer elektrisch leitender Kontakt (24) ausgebildet, der im Ausführungsbeispiel flächig, aber auch partiell -wie der Frontkontakt- aufgebracht sein kann. In der Siliziumnitrid- oder -oxinitrid-Schicht (16) muß sich eine hohe Dichte positiver Ladung bestehend aus der natürlichen Ladung oder den durch Fremdionen eingebrachten befinden, die an der Oberfläche des p-dotierten Silizium-Basismaterials (12) eine aus Elektronen bestehende Inversionsschicht (20) induzieren. Die durch das Licht erzeugten Elektronen diffundieren sodann zur Vorderseite, also zu dem elektrisch leitenden Kontakt (18) und werden in dem durch die positiven Isolatorladungen (22) erzeugten elektrischen Feld beschleunigt und wandern entlang der gut leitenden Inversionsschicht (20) zu dem elektrisch leitenden Kontakt (18), um nach Durchtunneln der Siliziumoxidschicht (14) abgeleitet zu werden.

Ist eine entsprechend ausgebildete MIS-Inversionsschicht-Solarzelle nicht mehr spezifikationsgerecht, so kann durch Abtragen insbesondere der MIS-solarzellenspezifischen Schichten das Silizium-Basismaterial (12) für eine neu herzustellende Solarzelle wiederverwendet werden.

Das Abtragen der entsprechenden Schichten soll an Hand der nachfolgenden Beispiele näher erläutert werden.

Beispiel A:

Die Solarzelle (10) wird bei Temperaturen zwischen 50°C und 150°C, vorzugsweise im Temperaturbereich 100°C bis 120°C in $O-H_3PO_4$ eingetaucht. Nach kurzer Zeit -in Abhängigkeit von der gewählten Temperatur im Minutenbereich- löst sich der ganzflächige aus Aluminium bestehende elektrisch leitende Rückkontakt (24) unter Wasserstoffentwicklung auf. Nach einer weiteren im Bereich von Stunden liegenden Einwirkzeit löst sich sodann die frontseitige zweite Isolatorschicht (16) in Form von Siliziumoxinitrid einschließlich des elektrischen Kontakts (18), der ebenfalls aus Aluminium besteht, auf. Darauf erfolgt vorzugsweise ein Entfernen der in der Siliziumoxidschicht (14) vorhandenen Ionenelemente der ersten Hauptgruppe, vorzugsweise Cäsium. Anschließend kann das Silizium-Basismaterial (12), das auch als Wafer zu bezeichnen ist, einer Polierätze ausgesetzt werden, um sodann für die Herstellung einer neuen MIS-Inversionsschicht-Solarzelle in gewohnter Weise benutzt zu werden. Die Polierätze kann dabei eine Zusammensetzung von 1 Teil HF (50 %) und 6 Teilen $HNO_3$ (70 %) aufweisen.

Beispiel B:

Entsprechend dem Beispiel A kann der elektrisch leitende Kontakt (24) entfernt werden, wohingegen zur Beschleunigung des Prozesses die zweite Isolatorschicht (16) in Form von Siliziumnitrid mit einem Plasmaätzverfahren abgetragen wird. Dies kann entweder in einem $C_2F_6/O_2$- (Verhältnis 60%/40%) oder einem $NF_3$-plasmachemischen Ätzprozeß geschehen. Der aus Aluminium bestehende elektrisch leitende Kontakt (18) wird ebenfalls entsprechend des Abtragens des Kontakts (24) entfernt.

Vorzugsweise ist der Verfahrensablauf derart, daß zuerst die Schicht (22) entfernt und sodann die elektrischen Kontakte (18) und (24) in einem Arbeitsgang abgelöst werden. Das Polierätzen des Silizium-Basismaterials (12) erfolgt sodann entsprechend dem Beispiel A.

Beispiel C:

Die frontseitige Siliziumnitridschicht (16) einschließlich der Alkalimetall-Ionen und dem elektrisch leitenden Kontaktsystem (18) werden einem mechanischen Abrieb unterworfen. Hierzu wird die Solarzelle (10) auf einem Drehteller angeordnet und unter Zuhilfenahme eines Abrasivmittels behandelt. Das Entfernen des Kontaktes (24) sowie das Ätzen des Silizium-Basismaterials (12) erfolgt sodann entsprechend dem Beispiel A. Alternativ kann der Kontakt (24) auch durch mechanischen Abrieb entfernt werden.

Beispiel D:

Ist von der MIS-Inversionsschicht-Solarzelle (10) die zweite Isolatorschicht (16) in Form von Siliziumnitrid entfernt, so werden in einem plasmachemischen Ätzverfahren die elektrischen Kontakt (18) und (24) abgetragen. Hierzu wird die von der Siliziumnitrid-Schicht (16) befreite Zelle (10) einem Plasmareaktor zugeführt und mit Chlor als Ätzgas bei einer Plasmaleistung von 50 bis 500 Watt, vorzugsweise 150 bis 250 Watt behandelt. Typischerweise sollte sich der Ätzabtrag im Bereich von 1 $\mu$m pro Minute bewegen.

Sofern das Basismaterial (12) von sämtlichen Schichten (14), (16), (18), (24) befreit ist, müssen die neu aufzutragenden Schichten nicht auf der gleichen Seite wie die zuvor abgetragenen angeordnet werden. Vielmehr kann die ursprüngliche Frontseite der Solarzelle (10) als Rückseite der neuen Solarzelle benutzt werden und umgekehrt.

**Patentansprüche**

1. Verfahren zur Herstellung von Solarzellen durch Wiederverwendung von Silizium-Basismaterial (12) einer Metall-Isolator-Halbleiter-(MIS)-Inversionsschicht-Solarzelle, bei der auf einer Seite des Basismaterials ein erster elektrisch leitender flächig oder partiell ausgebildeter Kontakt als rückseitiger Kontakt und auf der gegenüberliegenden Seite MIS-solarzellenspezifische Schichten in Form einer ersten Isolatorschicht (14), wie Siliziumoxidschicht, ein auf dieser vorhandener vorzugsweise in Gitter- oder Fingerform ausgebildeter zweiter elektrisch leitender Kontakt (18) als Frontkontakt sowie eine weitere Isolatorschicht, wie Siliziumnitrid- oder-oxinitrid-Schicht, angeordnet sind, wobei zumindest die MIS-solarzellenspezifischen Schichten in Form der zweiten Isolatorschicht (16) und des zweiten elektrisch leitenden Kontakts (18) abgetragen und durch entsprechende neue Schichten ersetzt werden.

2. Verfahren nach Anspruch 1, **dadurch gekennzeichnet**, daß in der ersten Isolatorschicht (14) eingebettete Alkalimetall-Ionen wie Cäsium-Ionen entfernt werden.

3. Verfahren nach Anspruch 1, **dadurch gekennzeichnet**, daß die einzelnen Schichten selektiv abgetragen werden.

4. Verfahren nach Anspruch 1, **dadurch gekennzeichnet**, daß die Schichten durch einen chemischen oder plasmachemischen Ätzprozeß abgetragen werden.

5. Verfahren nach Anspruch 1, **dadurch gekennzeichnet**, daß zunächst die zweite Isolatorschicht (16) und sodann vorzugsweise gleichzeitig der erste und der zweite elektrisch leitende Kontakt (18, 24) abgetragen werden.

6. Verfahren nach Anspruch 1, **dadurch gekennzeichnet**, daß zum Entfernen des ersten und zweiten elektrisch leitenden Kontakts (18, 24) sowie der zweiten Isolatorschicht (16) die MIS-Inversionsschicht-Solarzelle (10) in eine Mineralsäure vorzugsweise in O-$H_3PO_4$ bei einer Temperatur zwischen 50°C und 100°C eingetaucht wird.

7. Verfahren nach Anspruch 1, **dadurch gekennzeichnet**, daß die zweite Isolatorschicht (16) durch Plasmaätzung in z.B. $C_2F_6/O_2$-Gasphase oder durch plasmachemische Ätzung z. B. in $NF_3$-Gasphase abgetragen wird.

8. Verfahren nach Anspruch 1, **dadurch gekennzeichnet**, daß die MIS-solarzellenspezifischen Schichten (16, 18) als Einheit z.B. mechanisch entfernt werden.

9. Verfahren nach Anspruch 1, **dadurch gekennzeichnet**, daß die elektrisch leitenden Kontakte (18, 24) plasmachemisch mit vorzugsweise Chlor als Ätzgas abgetragen werden.

10. Verfahren nach Anspruch 1,
**dadurch gekennzeichnet**,
daß die aufzutragenden neuen Schichten auf einer anderen Seite des Silizium-Basismaterials (12) als die entsprechenden abgetragenen Schichten angeordnet werden.

## Claims

1. A method for producing solar cells by re-using silicon base material (S) of a metal insulator semiconductor (MIS) inversion-layer solar cell, said solar cells having as a rear contact a first electrically conductive contact of full-area or partial type arranged on one side of the base material, having on the opposite side MIS solar cell-specific layers in form of a first insulating layer such as a silicon oxide layer, a second electrically conductive contact (18) provided on said first insulating layer and designed preferably in finger or lattice form, and a further insulating layer such as a silicon nitride or silicon oxynitride layer, where at least said MIS solar cell-specific layers in the form of the second insulating layer (16) and the second electrically conductive contact (118) are stripped off and replaced by corresponding new layers.

2. A method according to Claim 1,
**characterized in that**
alkali metal ions such as caesium ions embedded in the first insulating layer (14) are removed.

3. A method according to Claim 1,
**characterized in that**
the various layers are stripped off selectively.

4. A method according to Claim 1,
**characterized in that**
the layers are stripped off by a chemical or plasma-chemical etching process.

5. A method according to Claim 1,
**characterized in that**
the second insulating layer (16) is stripped off first and then, preferably simultaneously, the first and second electrical contacts (18, 24).

6. A method according to Claim 1.
**characterized in that**
to remove the first and second electrically conductive contacts (18, 24) and the second insulating layer (16) the MIS inversion-layer solar cell (10) can be immersed in a mineral acid, preferably O-$H_3PO_4$ at a temperature between 50°C and 100°C.

7. A method according to Claim 1,
**characterized in that**
the second insulating layer (16) is stripped off by plasma etching for example in a $C_2F_6/O_2$ gas phase or by plasma-chemical etching for example in an $NF_3$ gas phase.

8. A method according to Claim 1,
**characterized in that**
the MIS solar cell-specific layers (14, 18) can be removed as a unit, for example mechanically.

9. A method according to Claim 1,
**characterized in that**
the electrically conductive contacts (18, 24) are stripped off plasma-chemically, preferably with chlorine as the etchant gas.

10. A method according to Claim 1,
**characterized in that**
the new layers to be deposited are arranged on another side of the silicon base material (12) to that which was used for the stripped-off layers.

## Revendications

1. Procédé de fabrication de cellules solaires par récupération du matériau de base au silicium d'une cellule solaire à couche d'inversion avec semi-conducteur à isolateur métallique, sur laquelle sont disposés, d'un côté du matériau de base, un premier contact électroconducteur, servant de contact arrière et assurant une couverture complète ou partielle, et, du côté opposé, des couches spécifiques aux cellules solaires dotées d'un semi-conducteur à isolateur métallique, sous la forme d'une première couche isolante (14), telle qu'une couche d'oxyde de silicium , un deuxième contact électroconducteur (18) prévu sur celle-ci, comme contact frontal, de préférence sous forme de grille ou de doigt, ainsi qu'une autre couche d'isolateur, telle qu'une couche de nitrure de silicium ou de nitrure d'oxyde,
au moins les couches spécifiques aux cellules solaires dotées de semi-conducteurs à isolateur métallique, sous la forme de la deuxième couche isolante (16) et du deuxième contact électroconducteur (18) sont enlevées et remplacées par de nouvelles couches correspondantes.

2. Procédé suivant la revendication n° 1,
**caractérisé en ce que**
sont enlevés les ions métalliques alcalins, tels que les ions de césium, incorporés dans la première couche isolante (14).

3. Procédé suivant la revendication n° 1,
**caractérisé en ce que**
les diverses couches sont enlevées de manière sélective.

4. Procédé suivant la revendication n° 1,
**caractérisé en ce que**
les couches sont enlevées à l'aide d'un procédé caustique chimique ou plasmachimique.

5. Procédé suivant la revendication n° 1,
**caractérisé en ce que**
sont enlevées d'abord la deuxième couche isolante (16), puis, de préférence, simultanément le premier et le deuxième contact électroconducteur (18, 24).

6. Procédé suivant la revendication n° 1,
**caractérisé en ce que,**
pour l'enlèvement du premier contact et du deuxième contact électroconducteur (18, 24) ainsi que de la deuxième couche isolante (16), la cellule solaire à couche d'inversion avec semi-conducteur à isolateur métallique (10) est immergée dans un acide minéral, de préférence dans $0-H_3PO_4$, à une température comprise entre 50 °C et 100 °C.

7. Procédé suivant la revendication n° 1,
**caractérisé en ce que**
la deuxième couche isolante (16) est enlevée par décapage au plasma, en phase à gaz $C_2F_6/O_2$ par exemple, ou par décapage plasmachimique, en phase à gaz $NF_3$ par exemple.

8. Procédé suivant la revendication n° 1,
**caractérisé en ce que**
les couches spécifiques aux cellules solaires dotées d'un semi-conducteur à isolateur thermique (16, 18) sont enlevées comme unité, mécaniquement par exemple.

9. Procédé suivant la revendication n° 1,
**caractérisé en ce que**
les contacts électroconducteurs (18, 24) sont enlevés plasmachimiquement, avec de préférence du chlore en tant que gaz corrosif.

10. Procédé suivant la revendication n° 1,
**caractérisé en ce que**
les nouvelles couches à appliquer sont disposées sur une autre face du matériau de base au silicium (12) que les couches correspondantes enlevées.